# EUROPEAN PATENT APPLICATION

(11) **EP 2 738 817 A2**
(43) Date of publication of application: **04.06.2014**
(21) Application number: 13185338.4
(22) Date of filing: 20.09.2013
(51) Int. Cl.: H01L 31/032

(54) **Solar cell**

(30) Priority: 23.11.2012 US 201261729513 P; 10.01.2013 US 201361751219 P
(71) Applicant: Samsung SDI Co., Ltd., Yongin-si, Gyeonggi-do (KR)
(72) Inventor: Kim, Hyun-Jong, Chungcheongnam-do 331-300 (KR)
(74) Representative: Mounteney, Simon James

(57) **Abstract**

The present invention relates to a solar cell with a double graded bandgap energy profile and a flat bandgap energy profile between the double graded bandgap energy profile.

## Description

### BACKGROUND OF THE INVENTION

### Field of the Invention

The present invention relates to a solar cell.

### Description of the Related Art

Recently, depletion of energy resources and problems regarding the environment of the Earth accelerate development of clean energies. From among various types of clean energies, solar power generation using solar cells directly converts solar light to electricity, thus being focused on as a new energy source.

However, costs for power generation using current industrial solar cells are still relatively high as compared to thermal power generation. For wide application of solar cells, it is necessary to improve power generating efficiency of solar cells.

### SUMMARY OF THE INVENTION

The present invention provides a solar cell as claimed in claims 1 to 12 and a method as claimed in claims 13 to 15 for the manufacture of said solar cell.

### BRIEF DESCRIPTION OF THE DRAWINGS

FIG. 1 is a schematic sectional view of a solar cell according to an embodiment of the present invention;
FIG. 2 is a diagram showing bandgap energy distribution in a light absorbing layer according to an embodiment of the present invention in the solar cell of FIG. 1;
FIG. 3 shows concentration interval distribution of Ga atoms according to depths of a light absorbing layer having the bandgap energy distribution of FIG. 2;
FIG. 4 shows concentration interval distribution of S atoms according to depths of a light absorbing layer having the bandgap energy distribution of FIG. 2;
FIG. 5 shows concentration bandgap energy profile according to depths of a light absorbing layer having the bandgap energy distribution of FIG. 2;
FIG. 6 is a graph showing a short-circuit current multiplied by open circuit voltage of a solar cell in sunlight according to an embodiment of the present invention; and
FIGS. 7 through 13 are schematic sectional views showing a method of manufacturing a solar cell according to an embodiment of the present invention.

### DETAILED DESCRIPTION OF THE INVENTION

The present invention will now be described more fully with reference to the accompanying drawings, in which exemplary embodiments of the invention are shown. The invention may, however, be embodied in many different forms and should not be construed as being limited to the embodiments set forth herein; rather, these embodiments are provided so that this disclosure will be thorough and complete, and will fully convey the concept of the invention to those skilled in the art. The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. It will be understood that although the terms first and second are used herein to describe various elements, these elements should not be limited by these terms. Like numbers refer to like elements throughout.

In the drawings, the thicknesses of layers and regions are exaggerated for clarity. It will also be understood that when a layer is referred to as being "on" another layer or substrate, it can be directly on the other layer or substrate, or intervening layers may also be present. However, when a layer is referred to as being "directly on" another layer or substrate, no intervening layer is present.

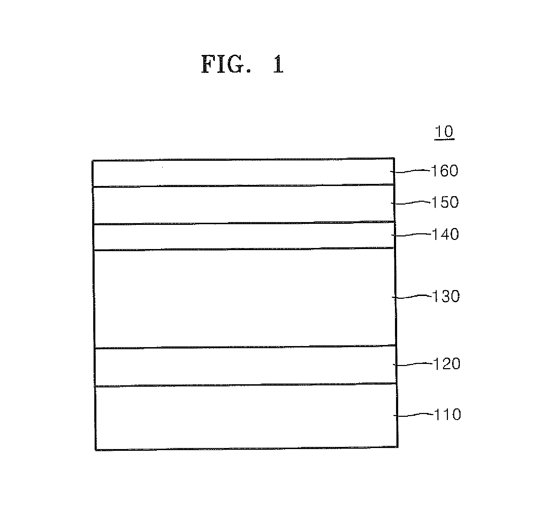

FIG. 1 is a schematic sectional view of a solar cell 10 according to an embodiment of the present invention.

Referring to FIG. 1, the solar cell 10 is a rear electrode type solar cell and includes a light absorbing layer 130, which is formed to have double graded bandgap energy having different grades and flat bandgap energy between the double graded bandgap energy.

In detail, the solar cell 10 includes a substrate 110, a rear electrode layer 120 formed on the substrate 110, the light absorbing layer 130 formed on the rear electrode layer 120, a buffer layer 140 formed on the light absorbing layer 130, and a transparent electrode layer 150 formed on the buffer layer 140. An anti-reflection layer 160 is formed on the transparent electrode layer 150.

In an embodiment of the present invention the substrate used in the solar cell is a glass substrate, a polymer substrate, a ceramic or stainless steel, optionally wherein:
(a) when the substrate is a glass substrate it is formed of sodalime glass, high strained point soda glass, low iron tempered glass;
(b) when the substrate is a polymer substrate it is formed of polyimide or a flexible polymer; or
(c) when the substrate is a ceramic it is alumina.

The substrate 110 used in the solar cell 10 may be a glass substrate or a polymer substrate having excellent phototransmissivity. For example, the glass substrate may be formed of sodalime glass or high strained point soda glass, whereas the polymer substrate may be formed of polyimide. However, the present invention is not limited thereto. Furthermore, the glass substrate may be formed of low iron tempered glass to protect devices therein from external shocks and to improve transmittance of solar light. Particularly, since low iron sodalime glass releases sodium (Na) ions at a process temperature over 500°C, the low iron sodalime glass may further improve efficiency of the light absorbing layer 130. Furthermore, the substrate 110 may also be formed of a ceramic, such as alumina, stainless steel, or a flexible polymer.

The rear electrode layer 120 may be formed of a metal having excellent conductivity and light reflectivity, such as molybdenum (Mo), aluminium (Al), or copper (Cu), to collect charges formed via photovoltaic effect and reflect light transmitted through the light absorbing layer 130, such that the light is re-absorbed by the light absorbing layer 130. In an embodiment of the present invention the rear electrode layer:
(a) has a thickness from about 200nm to about 500nm; and/or
(b) is doped with alkali ions, such as Na ions; and/or
(c) is formed as a multi-layer.

Particularly, the rear electrode layer 120 may contain Mo in consideration of high conductivity, ohmic contact with the light absorbing layer 130, and high temperature stability in selenium (Se) or sulphur (S) atmosphere associated with formation of the light absorbing layer 130. The rear electrode layer 120 may have a thickness from about 200nm to about 500nm.

Meanwhile, the rear electrode layer 120 may be doped with alkali ions, such as Na ions. For example, during growth of the light absorbing layer 130, alkali ions implanted to the rear electrode layer 120 are mixed into the light absorbing layer 130 and may inflict structural advantages to the light absorbing layer 130 and improve conductivity of the light absorbing layer 130. Therefore, open circuit voltage V_{OC} of the solar cell 10 increases, and thus efficiency of the solar cell 10 may be improved.

Furthermore, the rear electrode layer 120 may be formed as a multi-layer to secure sufficient adherence to the substrate 110 and sufficient resistant characteristic of the rear electrode layer 120.

The light absorbing layer 130 according to an embodiment of the present invention may include quinary compound of Cu-In-Ga-Se-S with a chemical formula of Cu(InₓGa₁₋ₓ)(Se_{y}S_{1-y}). In an embodiment of the present invention in the crystal lattice structure of the Cu(InₓGa₁₋ₓ)(Se_{y}S_{1-y}) compound, In is partially replaced by Ga and Se is partially replaced by S. In an embodiment of the present invention x is 0. 01≤ x ≤0.25, and y is 0.1≤ y ≤0.30. In an embodiment of the present invention, Ga has a grade towards the rear electrode layer. In an embodiment of the present invention the Ga concentration may differ by less than 10% throughout the light absorbing layer, optionally the Ga concentration may be differ by less than 5% throughout the light absorbing layer. In an embodiment of the present invention the Ga concentration may vary between 0.5% and 10%, optionally between 2% and 5%.

In an embodiment of the present invention the light absorbing layer has a first and a second maximal S concentration, the first maximal S concentration being towards the interface with the rear electrode layer and the second maximal S concentration being towards the interface with the buffer layer, optionally wherein the universal minima concentration of S is between the first and second maximal S concentrations. In an embodiment of the present invention, the S concentration may be represented by a S/(Se+S) mole ratio. In an embodiment of the present invention the first and the second maximal S concentration are independently preferably from about 0.30 to about 0.50, preferably about 0.32 to about 0.45. In an embodiment of the present invention the universal minima concentration of S is represented by a S/(Se+S) mole ratio of from about 0.02 to about 0.12, preferably about 0.05 to about 0.10.

In an embodiment of the present invention the light absorbing layer 130 according to an embodiment of the present invention may include a first light

Meanwhile, as described below, the light absorbing layer 130 has double graded bandgaps having different grades and a flat bandgap between the double graded bandgaps, thereby improving efficiency of the solar cell 10.

In an embodiment of the present invention, in the flat bandgap energy profile the difference between the largest bandgap energy and the lowest bandgap energy in the flat bandgap energy profile is less than or equal to 0.2eV, optionally less than or equal to 0.1eV or less than or equal to 0.04eV. In an embodiment of the present invention, the difference between the largest bandgap energy and the lowest bandgap energy in the flat bandgap energy profile is from 0.0 eV to 0.2eV, optionally 0.005eV to 0.1eV, optionally from 0.01 eV to 0.04eV.

In an embodiment of the present invention the light absorbing layer has a first and a second graded region either side of the flat bandgap energy profile, where:
the first graded region has a graded bandgap energy profile that increases toward the interface between the rear electrode layer and the light absorbing layer; and
the second graded region has a bandgap energy profile that increases in a direction from the flat bandgap energy profile toward the interface between the light absorbing layer and the buffer layer.

In an embodiment of the present invention the graded bandgap energy profiles are adjusted to decrease toward the flat bandgap energy profile, optionally wherein the flat bandgap energy profile comprises the universal minimum bandgap energy.

The buffer layer 140 reduces a difference between bandgap energies of the light absorbing layer 130 and the transparent electrode layer 150 described below and reduces recombination of electrons and holes that may occur between the light absorbing layer 130 and the transparent electrode layer 150. In an embodiment of the present invention the buffer layer 140 may be formed of CdS, ZnS, In₂S₃, ZnₓMg₁₋ₓO, etc. For example, if the buffer layer 140 is formed of CdS, a CdS thin-film is formed of a n-type semiconductor, where resistance thereof may be reduced by doping the CdS thin-film with In, Ga, Al, etc.

The transparent electrode layer 150 may be formed of a material having high phototransmissivity, such that solar light may be transmitted to the light absorbing layer 130.

Furthermore, to function as an electrode layer, the transparent electrode layer 150 may be formed of a conductive material having a low resistance. The transparent electrode layer 150 may be formed of zinc oxide (ZnO) doped with boron (B) or Al or indium tin oxide (ITO). ZnO doped with B or Al is suitable to be used as an electrode due to low resistance. Particularly, ZnO doped with B increase transmittance of lights of near-infrared ray domain, thereby increasing short-circuit current of a solar cell.

Furthermore, , an anti-reflection layer may be further formed on the transparent electrode layer 150. Efficiency of a solar cell may be improved by reducing reflection loss of solar light by forming the anti-reflection layer on the transparent electrode layer 150. The anti-reflection layer may be formed of MgF₂.

Furthermore, the anti-reflection layer may be textured to reduce reflection of incident solar light and increase absorption of the incident solar light to the light absorbing layer 130.

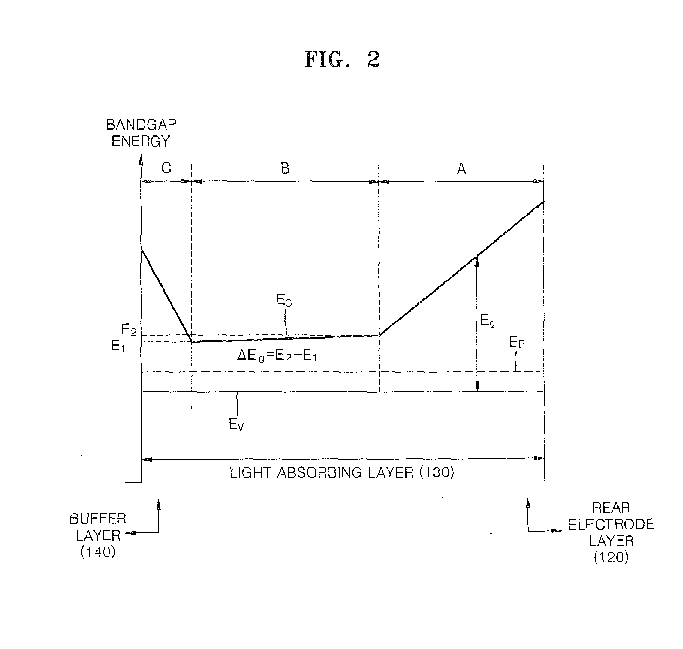

FIG. 2 is a diagram showing bandgap energy distribution in the light absorbing layer 130 according to an embodiment of the present invention in the solar cell 10 of FIG. 1,

Referring to FIGS. 1 and 2, E_{V} denotes valence energy band, whereas E_{C} denotes conduction energy band. Bandgap energy E_{g} refers to an energy gap between the conduction energy band E_{C} and the valence energy band E_{V}.

Bandgap energy E_{g} of the light absorbing layer 130 may be calculated by using E_{g} calculation equation. In other words, the bandgap energy E_{g} may be calculated by using E_{g} calculation equation based on Ga content and S content.

Generally, if bandgap energy E_{g} nearby the rear electrode layer 120 is large, electrons and holes in the light absorbing layer 130 may be prevented from being recombined, and thus efficiency of the solar cell 10 may be improved.

Furthermore, if bandgap energy E_{g} nearby the rear electrode layer 120 is large, the open circuit voltage V_{OC} of the solar cell 10 increases, and thus efficiency of the solar cell 10 is improved.

Here, the open circuit voltage V_{OC} refers to a difference between potentials formed at two opposite ends of the solar cell 10 when the infinite impedance is applied to the solar cell 10 and light is incident to the solar cell 10. In other words, the open circuit voltage V_{OC} is the maximum current that may be obtained from the solar cell 10. Generally, if a current of open circuit is significantly smaller than that of a short circuit, the open circuit voltage V_{OC} is proportional to intensity of incident light.

Furthermore, if a p-n junction is formed properly, the higher the band-gap energy of a semiconductor, the greater the open circuit voltage Voc.

Therefore, if bandgap energy E_{g} at the interface between the light absorbing layer 130 and the rear electrode layer 120 increases, recombination of electrons and holes may be prevented and open circuit voltage V_{OC} may increase, and thus the overall efficiency of the solar cell 10 may be improved.

Referring to FIG. 2, a region A is a region of the light absorbing layer 130 close to the rear electrode layer 120. The light absorbing layer 130 has graded bandgap energy, where bandgap energy increases toward the interface between the rear electrode layer 120 and the first light absorbing layer 130.

Therefore, the region A has the largest band gap energy E_{g} at the interface between the rear electrode layer 120 and the t light absorbing layer 130, and bandgap energy decreases in a direction from the rear electrode layer 120 to the light absorbing layer 130.

Meanwhile, a region B is a region between the region A to the top surface of the light absorbing layer 130 and is an internal region of the light absorbing layer 130. The region B has flat bandgap energy. A difference (ΔEg = E₂ - E₁) between the largest bandgap energy E₂ and the lowest bandgap energy E₁ in the region B may be less than or equal to 0.2eV.

Furthermore, the bandgap energy of the region B is smaller than bandgap energy of the region A and bandgap energy of a region C.

The smaller the bandgap energy of the region B is, the more efficient the photovoltaic effect may be. If the region B has large bandgap energy, even if the first light absorbing layer 131 receives solar light, it is not easy for electrons in the valence band to be excited to the conduction band. Therefore, the overall power generating efficiency of the solar cell 10 may be deteriorated.

Therefore, the region A has graded bandgap energy that is adjusted to decrease toward the region B and the region B has the minimized bandgap energy, and thus power generating efficiency of the solar cell 10 may be improved. However, efficiency of the solar cell 10 is not unconditionally proportional to width of flat bandgap energy, and it may be necessary to adjust bandgap energy of the region B to have an optimal width.

Furthermore, the region C is a region of the light absorbing layer 130 and covers an internal region of the light absorbing layer 130 and the interface between the light absorbing layer 130 and the buffer layer 140, which is an n- type semiconductor.

The region C has graded bandgap energy, where bandgap energy increases in a direction from an internal region of the light absorbing layer 130 toward the interface between the light absorbing layer 130 and the buffer layer 140.

Therefore, bandgap energy increased in the region C may increase open circuit voltage, thereby improving efficiency of the solar cell 10.

The bandgap energy E_{g} distribution in the light absorbing layer 130 may be controlled by adjusting process conditions for forming the light absorbing layer 130 and contents of Ga and S.

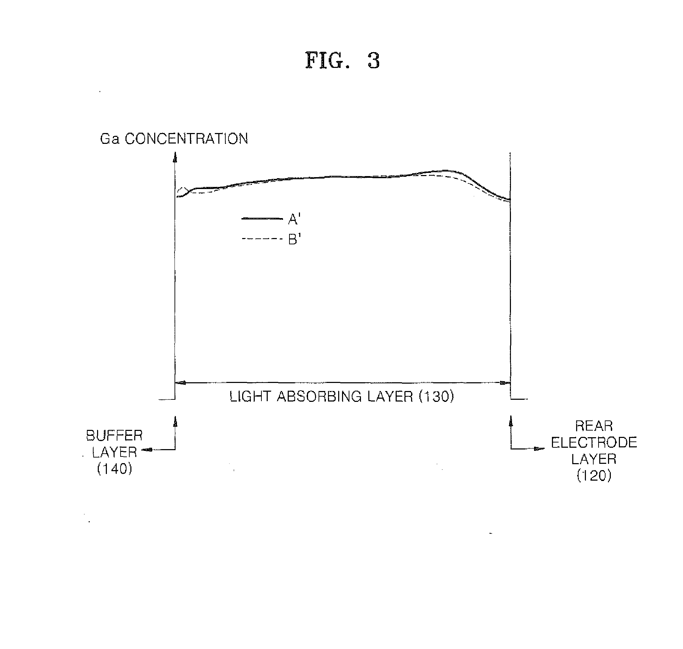

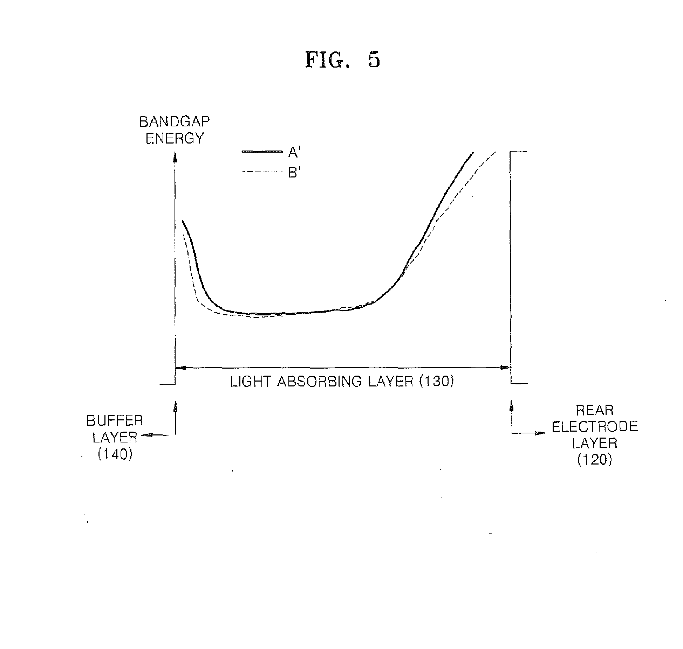

FIG. 5 shows bandgap energy profiles for two examples (A' and B') according to Ga concentration in the light absorbing layer shown in FIG. 3, according to another embodiment. Here, in one embodiment of the present invention, Ga concentration varies by less than 10%, throughout the light absorbing layer. In another embodiment, Ga concentration varies by less than 5%, throughout the light absorbing layer. For example, this feature may be between 0.5% and 10% and between 2% and 5%.

In one embodiment (e.g. as shown in the flat bandgap energy region of FIG. 5), the difference (ΔEg = E2 - E1) between a largest bandgap energy E2 and a lowest bandgap energy E1 is less than or equal to 0.2eV. In some embodiments, the difference (ΔEg = E2 - E1) between the largest bandgap energy E2 and the lowest bandgap energy E1 in the substantially flat bandgap energy profile is less than or equal to 0.1eV. In some embodiments, the difference (ΔEg = E2 -E1) between the largest bandgap energy E2 and the lowest bandgap energy E1 in the substantially flat bandgap energy profile is less than or equal to 0.04eV. For example, this bandgap may be between 0.0 eV to 0.2eV, optionally 0. 005eV to 0.1eV, optionally from 0.01eV to 0. 04eV.

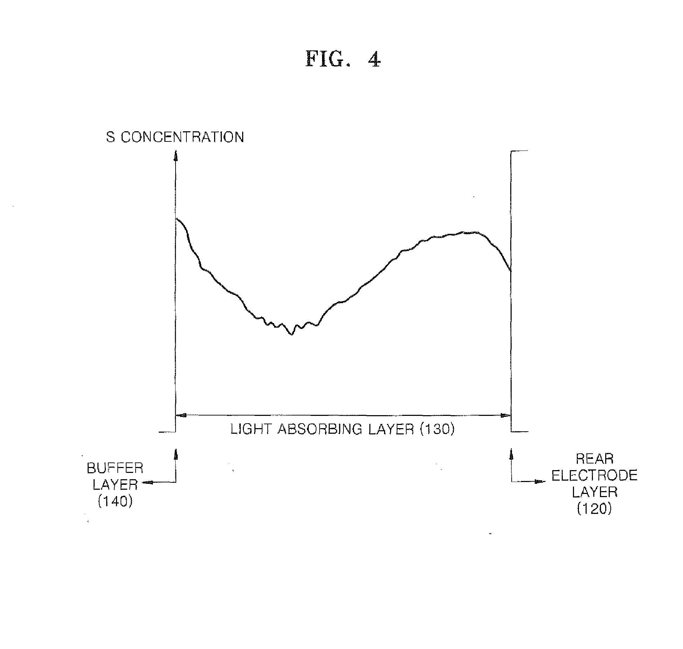

FIG. 3 shows concentration interval distribution of Ga atoms according to depths of a light absorbing layer having the bandgap energy distribution of FIG. 2, and FIG. 4 shows concentration interval distribution of S atoms according to depths of a light absorbing layer having the bandgap energy distribution of FIG. 2.

Referring to FIGS. 3 and 4, the region B having flat bandgap energy of FIG. 2 and the graded bandgap energy profiles A and C, in which bandgap energies increase from two opposite sides of the region B toward the interface between the light absorbing layer 130 and the rear electrode layer 120 and the interface between the light absorbing layer 130 and the buffer layer 140 may be formed by controlling concentration profiles of Ga and S according to depth of the light absorbing layer 130.

Furthermore, although concentration distributions of Ga and S are used for forming the bandgap energy distribution of FIG. 2 in FIGS. 3 and 4, the present invention is not limited thereto, and a bandgap energy distribution in which a flat region is formed in the region B of FIG. 2 may be formed by forming different types of concentration profiles. Furthermore, if the light absorbing layer 130 is formed of a Group III atom and a Group VI atom other than Ga and S, the bandgap energy distribution of FIG. 2 may be formed by using concentration profiles of the Group III tom and the Group VI atom other than Ga and S.

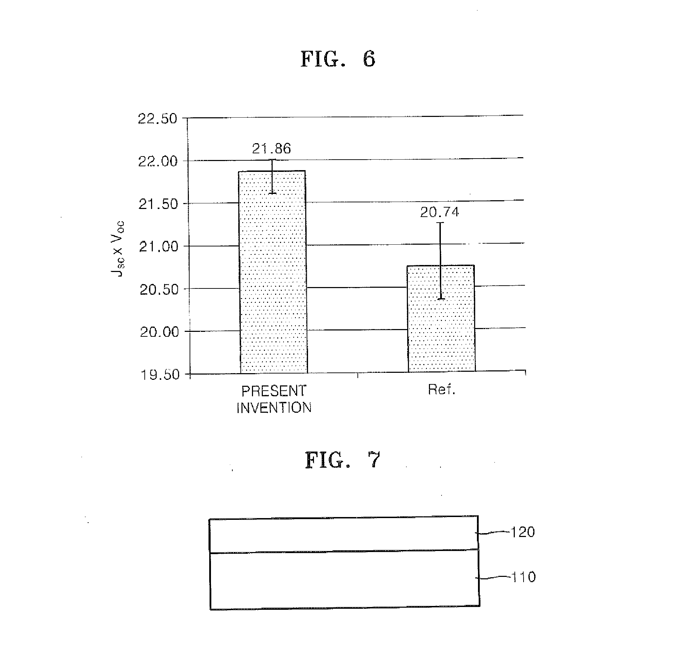

FIG. 6 is a graph showing a short-circuit current J_{SC} multiplied by open circuit voltage V_{OC} of a solar cell in sunlight according to an embodiment of the present invention. J_{SC}V_{OC}, which is the multiplication of the short-circuit current by the open circuit voltage, is proportional to efficiency of the solar cell. Therefore, efficiency of the solar cell increases as J_{SC}V_{OC} increases.

Referring to FIG. 6, the case in which flat band gap energy B (refer to FIG. 2) exists between the double graded bandgap energies A and C features larger J_{SC}V_{OC} value than the case (Ref.) in which only double graded bandgap energies exist, where an average of multiplication of open circuit voltages V_{OC} (mV) by short-circuit currents J_{SC} (mA/cm²) is 21.86.

In other words, according to an embodiment of the present invention, since the light absorbing layer 130, in which flat bandgap energy B (refer to FIG. 2) exists between double graded bandgap energies A and C (refer to FIG. 2) having different grades, is employed, thereby increasing J_{SC}V_{OC}. As a result, efficiency of a solar cell may be improved.

FIGS. 7 through 13 are schematic sectional views showing a method of manufacturing a solar cell according to an embodiment of the present invention.

In an embodiment of the present invention provided is a process for producing the above-defined solar cells comprising the following ordered steps:
(a) the rear electrode layer is formed on the substrate, optionally wherein the rear electrode layer is formed of Mo;
(b) forming a precursor layer on the rear electrode layer by:
   (i) forming a Cu-Ga-In layer on the rear electrode layer; or
   (ii) forming a Cu-Ga layer on the rear electrode layer and forming an In layer on the Cu-Ga layer;
(c) performing a first heat treatment with a Se-containing gas on the precursor layer including either the Cu-Ga-In layer or the Cu-Ga layer and the In layer to form a layer formed of Cu(InₓGa₁₋ₓ)Se₂;
(d) performing a second heat treatment on the first light absorbing layer with a S-containing gas to form the second light absorbing layer formed of Cu(InₓGa₁₋ₓ)(SeyS_{1-y}) as the light absorbing layer;
(e) forming a buffer layer on the second light absorbing layer; and
(f) forming a transparent electrode layer on the buffer layer.

In various embodiments of the present invention, the following process steps are preferably included:
(i) in step (a), the rear electrode layer is formed by DC sputtering using a Mo target or by chemical vapor deposition (CVD); and/or
(ii) in step (b)(i), the precursor layer made of Cu-Ga-In is formed via sputtering by using Cu-Ga-In alloy as a target material; and/or
(iii) in step (b)(ii), the precursor layer is formed via DC sputtering by using Cu-Ga alloy as a target material, followed by sputtering using an In-based material as a target material; and/or
(iv) in step (c), the first heat treatment is performed in a vacuum chamber, where the Se-containing gas is a mixed gas including an inert gas and hydrogen selenide (H2Se) gas, optionally wherein the first heat treatment is performed at a temperature from about 300°C to about 500°C for a period of time from about 5 minutes to about 40 minutes; and/or
(v) in step (d), the second heat treatment is performed in a vacuum chamber, where the S-containing gas is a mixed gas including an inert gas and hydrogen sulfide (H2S) gas, optionally wherein the second heat treatment is performed at a temperature from about 500°C to about 700°C for a period of time from about 10 minutes to about 100 minutes; and/or
(vi) in step (e), the buffer layer comprises a CdS based material via chemical bath deposition (CBD); and/or
(vii) in step (f), the transparent electrode layer comprises ZnO and is formed via RF sputtering by using ZnO as a target material, reactive sputtering by using Zn as a target material, or metal organic chemical vapor deposition (MOCVD).

Referring to FIG. 7, in an embodiment, the rear electrode layer 120 is formed on the substrate 110. As described above, the rear electrode layer 120 may be formed of Mo, which is a material satisfying the overall demands of the rear electrode layer 120. The rear electrode layer 120, in an embodiment, may be formed by DC sputtering using Mo target. Furthermore, in an embodiment, the rear electrode layer 120 may be formed via chemical vapor deposition (CVD).

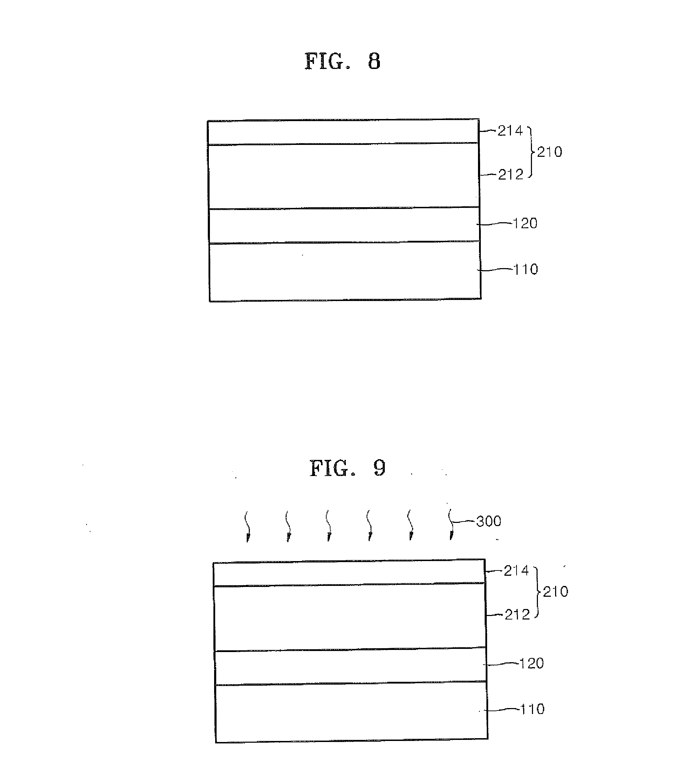

Referring to FIG. 8, in an embodiment, a Cu-Ga layer 212 is formed on the rear electrode layer 120. Here, in an embodiment, the Cu-Ga layer 212 may be formed via DC sputtering by using Cu-Ga alloy as a target material. Here, since Ga is a material that may hardly be a target material by itself, the Cu-Ga alloy may be used as a target material.

Next, in an embodiment, an In layer 214 is formed on the Cu-Ga layer 212. In an embodiment, the In layer 214 may be formed via sputtering by using an In-based material as a target material.

Accordingly, a precursor layer 210 including the Cu-Ga layer 212 and the In layer 214 is formed on the rear electrode layer 120. Here, although the precursor layer 210 may be formed via the two-stage operations as described above, the precursor layer 210 may also be formed via sputtering by using Cu-Ga-In alloy as a target material. In this case, the precursor layer 210 is formed as a Cu-Ga-In layer (not shown).

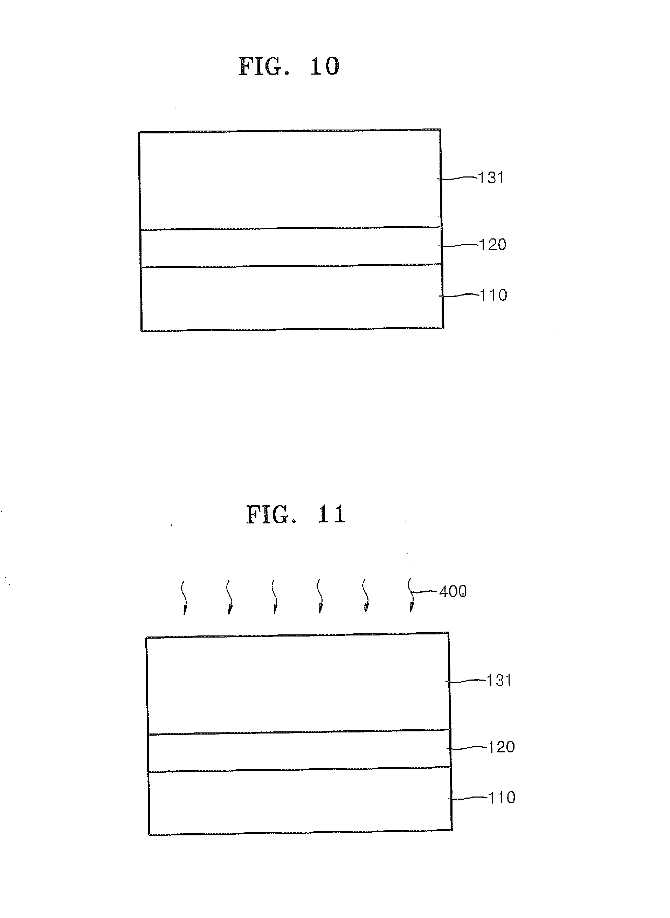

Referring to FIGS. 10 and 11, in an embodiment, the layer 131 formed of Cu(InₓGa₁₋ₓ)Se₂ is formed by performing first heat treatment to the precursor layer 210 including the Cu-Ga layer 212 and the In layer 214 by using a Se-containing gas 300.

In an embodiment, the first heat treatment is performed in a vacuum chamber, where the Se-containing gas 300 may be a mixed gas including an inert gas and hydrogen selenide (H₂Se) gas.

Furthermore, in an embodiment, the first heat treatment may be performed at a temperature from about 300°C to about 500°C for a period of time from about 5 minutes to about 40 minutes, preferably from about 400°C to about 480°C for selenization, optionally from about 410°C to about 450°C, for 5 minutes to about 40 minutes, optionally about 15 minutes to about 25 minutes.

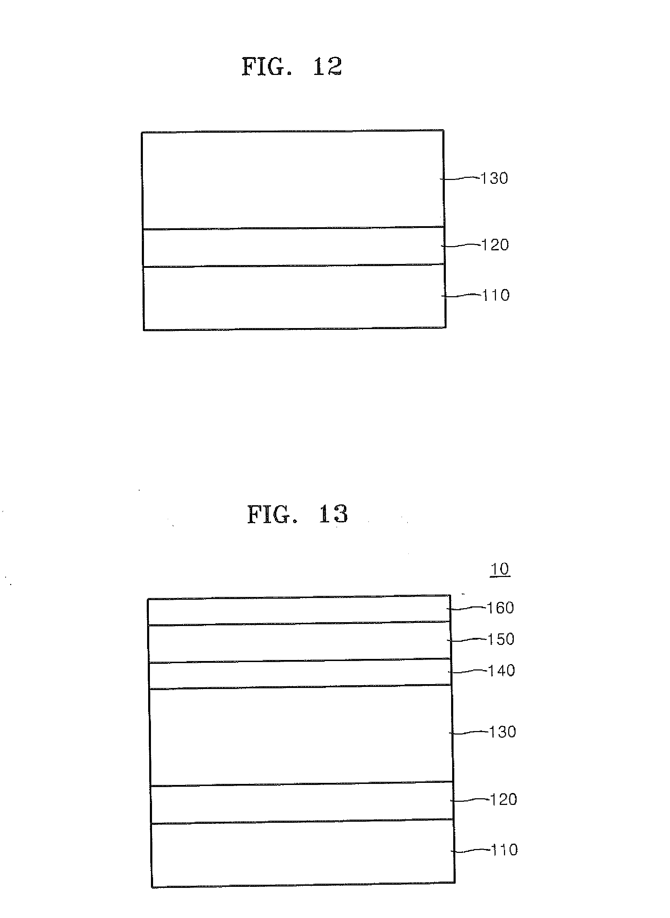

Referring to FIGS. 11 and 12, a second heat treatment is performed to the layer 131 by using a S-containing gas 400, thereby forming the light absorbing layer 130 formed of Cu(InₓGa₁₋ₓ)(SeyS_{1-y}). Furthermore, during the second heat treatment, temperature, time, and concentrations of S-containing gas may be controlled, such that S content in the first light absorbing layer 130 increases toward the rear electrode layer 120 as shown in FIG. 4.

In an embodiment, the second heat treatment is performed in a vacuum chamber, where the S-containing gas 400 may be a mixed gas including an inert gas and hydrogen sulfide (H₂S) gas.

Furthermore, in an embodiment, the second heat treatment may be performed at a temperature from about 500°C to about 700°C for a period of time from about 10 minutes to about 100 minutes, preferably 500°C to about 600°C for 25 minutes to about 80 minutes, optionally about 30 minutes to about 70 minutes and optionally about 30 minutes to about 60 minutes for sulfurization, preferably the sulfurization step is carried out at a temperature of from about 525°C to about 575°C, optionally from about 540°C to about 560°C.

Furthermore, temperatures, times, and concentrations of H₂Se and H₂S may controlled to form the light absorbing layer 130 having the bandgap energy distribution as shown in FIG. 2.

Referring to FIG. 13, the buffer layer 140 is formed on the light absorbing layer 130. The buffer layer 140 may be mainly formed of CdS based material via chemical bath deposition (CBD).

Next, the transparent electrode layer 150 is formed on the buffer layer 140. The transparent electrode layer 150 may be mainly formed of ZnO. Therefore, the transparent electrode layer 150 may be formed via RF sputtering by using ZnO as a target material, reactive sputtering by using Zn as a target material, or metal organic chemical vapor deposition (MOCVD).

Next, in an embodiment, an anti-reflection layer may be formed on the transparent electrode layer 150. The anti-reflection layer may be formed via an electron beam evaporation by using MgF₂.

According to embodiments of the present invention, the light absorbing layer 130 having double graded bandgaps having different grades and flat bandgap energy therebetween as shown in FIG. 2 may be formed.

Therefore, at the interface between the first light absorbing layer 131 and the rear electrode layer 120 and the interface between the second light absorbing layer 133 and the buffer layer 140, high bandgap energies may be formed, thereby increasing open circuit voltage. Furthermore, since the bandgap energy of a predetermined lower portion of the first light absorbing layer 131 contacting the second light absorbing layer 133 is flat, power generating efficiency of a solar cell may be improved.

While the present invention has been particularly shown and described with reference to embodiments thereof, it will be understood by those of ordinary skill in the art that various changes in form and details may be made therein without departing from the spirit and scope of the present invention as defined by the following claims.

## Claims

1. A solar cell, comprising:
a substrate;
a rear electrode layer formed on the substrate;
a light absorbing layer formed on the rear electrode layer;
a buffer layer formed on the light absorbing layer; and
a transparent electrode layer formed on the buffer layer,
**characterised in that** the light absorbing layer is formed to have a double graded bandgap energy profile having different grades and a flat bandgap energy profile between the different grades of the double graded bandgap energy profile.

2. The solar cell according to Claim 1, wherein the light absorbing layer is a quinary compound of Cu-In-Ga-Se-S with a chemical formula of Cu(InₓGa₁₋ₓ)(Se_{y}S_{1-y}).

3. The solar cell according to Claim 2 wherein the Ga has a grade towards the rear electrode layer.

4. The solar cell according to any one of Claims 1 to 3, wherein the light absorbing layer has a first and a second graded region either side of the flat bandgap energy profile, where:
the first graded region has a graded bandgap energy profile that increases toward the interface between the rear electrode layer and the light absorbing layer; and
the second graded region has a bandgap energy profile that increases in a direction from the flat bandgap energy profile toward the interface between the light absorbing layer and the buffer layer.

5. The solar cell according to any one of Claims 1 to 4, wherein the graded bandgap energy profiles are adjusted to decrease toward the flat bandgap energy profile, optionally wherein the flat bandgap energy profile comprises the universal minimum bandgap energy.

6. The solar cell according to any one of Claims 1 to 5, wherein in the flat bandgap energy profile the difference between the largest bandgap energy and the lowest bandgap energy in the flat bandgap energy profile is less than or equal to 0.2eV,

7. The solar cell according to claim 6, wherein the difference between the largest bandgap energy and the lowest bandgap energy in the flat bandgap energy profile is less than or equal to 0.04eV.

8. The solar cell according to any one of Claims 1 to 7, wherein the substrate used in the solar cell is a glass substrate, a polymer substrate, a ceramic or stainless steel, optionally wherein:
(a) when the substrate is a glass substrate it is formed of sodalime glass, high strained point soda glass, low iron tempered glass;
(b) when the substrate is a polymer substrate it is formed of polyimide or a flexible polymer; or
(c) when the substrate is a ceramic it is alumina.

9. The solar cell according to any one of Claims 1 to 8, wherein the rear electrode layer is formed of a metal selected from molybdenum (Mo), aluminium (Al), or copper (Cu), optionally wherein the rear electrode layer:
(a) has a thickness from about 200nm to about 500nm; and/or
(b) is doped with alkali ions, such as Na ions; and/or
(c) is formed as a multi-layer.

10. The solar cell according to any one of Claims 1 to 9, wherein:
(a) the buffer layer is formed of one or more of CdS, ZnS, In₂S₃, ZnₓMg₁₋ₓO, optionally wherein the buffer layer is a n-type semiconductor; and/or
(b) the transparent electrode layer is formed of zinc oxide (ZnO) doped with boron (B) or Al or indium tin oxide (ITO); and/or
(c) the solar cell further comprises an anti-reflection layer formed on the transparent electrode layer, optionally wherein:
(i) the anti-reflection layer is formed of MgF₂; and/or
(ii) the anti-reflection layer is textured to reduce reflection of incident solar light and increase absorption of the incident solar light to the light absorbing layer.

11. The solar cell according to any one of Claims 2 to 10, wherein the light absorbing layer has a first and a second maximal S concentration, the first maximal S concentration being towards the interface with the rear electrode layer and the second maximal S concentration being towards the interface with the buffer layer, optionally wherein the universal minima concentration of S is between the first and second maximal S concentrations.

12. The solar cell according to any one of Claims 2 to 11, wherein the Ga concentration differs by less than 10% throughout the light absorbing layer.

13. A method of preparing a rear electrode type solar cell as claimed in any one of Claims 1 to 12, comprising the following ordered steps:
(a) the rear electrode layer is formed on the substrate, optionally wherein the rear electrode layer is formed of Mo;
(b) forming a precursor layer on the rear electrode layer by:
(i) forming a Cu-Ga-In layer on the rear electrode layer; or
(ii) forming a Cu-Ga layer on the rear electrode layer and forming an In layer on the Cu-Ga layer;
(c) performing a first heat treatment with a Se-containing gas on the precursor layer including either the Cu-Ga-In layer or the Cu-Ga layer and the In layer to form a layer formed of Cu(InₓGa₁₋ₓ)Se₂;
(d) performing a second heat treatment on the first light absorbing layer with a S-containing gas to form the second light absorbing layer formed of Cu(InₓGa₁₋ₓ)(SeyS_{1-y}) as the light absorbing layer;
(e) forming a buffer layer on the second light absorbing layer; and
(f) forming a transparent electrode layer on the buffer layer.

14. The method of Claim 13, wherein the method further comprises the step of forming an anti-reflection layer on the transparent electrode layer after step (f), optionally wherein the anti-reflection layer is formed via an electron beam evaporation by using MgF₂.

15. The method of Claim 13 or Claim 14, wherein:
(i) in step (a) of Claim 13, the rear electrode layer is formed by DC sputtering using a Mo target or by chemical vapor deposition (CVD); and/or
(ii) in step (b)(i) of Claim 13, the precursor layer made of Cu-Ga-In is formed via sputtering by using Cu-Ga-In alloy as a target material; and/or
(iii) in step (b)(ii) of Claim 13, the precursor layer is formed via DC sputtering by using Cu-Ga alloy as a target material, followed by sputtering using an In-based material as a target material; and/or
(iv) in step (c) of Claim 13, the first heat treatment is performed in a vacuum chamber, where the Se-containing gas is a mixed gas including an inert gas and hydrogen selenide (H₂Se) gas, optionally wherein the first heat treatment is performed at a temperature from about 300°C to about 500°C for a period of time from about 5 minutes to about 40 minutes; and/or
(v) in step (d) of Claim 13, the second heat treatment is performed in a vacuum chamber, where the S-containing gas is a mixed gas including an inert gas and hydrogen sulfide (H₂S) gas, optionally wherein the second heat treatment is performed at a temperature from about 500°C to about 700°C for a period of time from about 10 minutes to about 100 minutes; and/or
(vi) in step (e) of Claim 13, the buffer layer comprises a CdS based material via chemical bath deposition (CBD); and/or
(vii) in step (f) of Claim 13, the transparent electrode layer comprises ZnO and is formed via RF sputtering by using ZnO as a target material, reactive sputtering by using Zn as a target material, or metal organic chemical vapor deposition (MOCVD).
